# EUROPEAN PATENT APPLICATION

(11) **EP 4 645 388 A1**
(43) Date of publication of application: **05.11.2025**
(21) Application number: 25164447.2
(22) Date of filing: 18.03.2025
(51) Int. Cl.: H01L 23/522, H10D 1/20, H01L 21/761, H01L 21/763, H01L 23/64, H01L 23/66

(54) **PATTERNED DEEP TRENCH ISOLATION FOR PASSIVE DEVICES**

(30) Priority: 30.04.2024 US 202418651249
(71) Applicant: NXP B.V., 5656 AG Eindhoven (NL)
(72) Inventor: BRUNETS, Ihor, 5656 AG Eindhoven (NL); MAGNEE, Petrus Hubertus Cornelis, 5656 AG Eindhoven (NL); DONKERS, Johannes Josephus Theodorus Marinus, 5656 AG Eindhoven (NL); SEBEL, Patrick, 5656 AG Eindhoven (NL)
(74) Representative: Hardingham, Christopher Mark

(57) **Abstract**

An electronic device and related method of fabricating such a device includes an electrically-conductive passive device (e.g., an inductor or transmission line) fabricated above an upper surface of a semiconductor substrate that has a body portion disposed between the upper surface and a lower surface of the substrate. The body portion is doped n-type or p-type and the passive device is separated from the upper surface by one or more layers of electrically insulating material. The substrate includes a set of electrically-insulating isolation trenches disposed beneath the passive device that extend from the upper surface of the substrate toward the lower surface of the substrate and the isolation trenches are disjoint from each other.

## Description

### TECHNICAL FIELD

Embodiments of the disclosure are related to semiconductor integrated circuits that include passive components such as inductors and transmission lines.

### BACKGROUND

Trench isolation techniques including shallow trench isolation and deep trench isolation can be used separately and in combination to reduce undesirable capacitive coupling and current leakage in semiconductor integrated circuits. Typically, deep trenches completely surround one or more transistors or other semiconductor devices fabricated on or within a semiconductor substrate. Conventional silicon substrates designed with deep trench isolation features include lattice-like patterns of interconnected deep trenches. In silicon wafers, the trenches used for deep trench isolation are lined with an insulating material such as silicon dioxide but filled with polysilicon to avoid problems that can arise due to the mismatch in thermal expansion coefficients between crystalline silicon and silicon oxide or other insulating materials.

### BRIEF SUMMARY

In an example embodiment, an electronic device includes a semiconductor substrate having an upper surface, a lower surface, and a doped body portion having a first conductivity type that is n-type or p-type that is disposed between the upper surface and the lower surface. The device further includes one or more electrically-insulating layers disposed above the upper surface; an electrically-conductive passive device fabricated above the one or more electrically-insulating layers that is separated from the body portion of the substrate by the one or more electrically-insulating layers; and a set of electrically-insulating isolation trenches disposed beneath the passive device that extend from the upper surface of the substrate toward the lower surface of the substrate. The isolation trenches are disjoint from each other.

In another example embodiment a method includes forming a set of electrically-insulating isolation trenches in a semiconductor substrate that extend from an upper surface of the substrate toward a lower surface of the substrate. The method also includes forming one or more insulating layers disposed above the upper surface of the substrate; and forming an electrically-conductive passive device that is separated from the upper surface of the substrate by the one or more electrically-insulating layers. The substrate includes a doped body portion having a first conductivity type that is n-type or p-type that is disposed between the upper surface and the lower surface of the substrate and the isolation trenches are disjoint from each other.

### BRIEF DESCRIPTION OF THE SEVERAL VIEWS OF THE DRAWINGS

The following Disclosure is illustrated by way of examples, embodiments and the like and is not limited by the accompanying Figures, in which like reference numbers indicate similar elements. The Figures along with the detailed description are incorporated and form part of the specification and serve to further illustrate examples, embodiments and the like, and explain various principles and advantages, in accordance with the disclosure.
FIG. 1A is a top plan view of a passive device fabricated on an example semiconductor substrate with patterned isolation trenches according to one or more embodiments.
FIG. 1B is a cross-sectional view of a portion of the substrate of FIG. 1A along the line A-A' of FIG. 1A.
FIG. 1C is a top plan view of the pattern of deep trenches in the substrate of FIG. 1A and FIG. 1B near the line A-A' of FIG. 1A
FIG. 2 is a cross-sectional view of a substrate with a passive device that is related to the substrates of FIG. 1A, FIG. 1B, and FIG 1C.
FIG. 3A is a cross-sectional view of a substrate with a passive device that is related to the substrates of FIG. 1A, FIG. 1B, FIG. 1C, and FIG. 2.
FIG. 3B is a top plan view showing an arrangement of trenches in a portion of the substrate of FIG. 3A.

### DETAILED DESCRIPTION

The following Detailed Description provides examples for the purposes of understanding and is not intended to limit the embodiments of this disclosure and uses of the same. Furthermore, there is no intention to be bound by any expressed or implied theory presented in the preceding technical field, background, or the following detailed description.

For simplicity and clarity of illustration, elements in the drawing figures are not necessarily drawn to scale. For example, the dimensions of some of the elements or regions in the figures may be exaggerated relative to other elements or regions to help improve understanding of embodiments of the disclosure. Directional references such as "top," "bottom," "left," "right," "above," "below," and so forth, unless otherwise stated, are not intended to require any preferred orientation, and are made with reference to the orientation of the corresponding figure or figures for purposes of illustration. In addition, the Figures and Detailed Description may omit well-known and conventional features for clarity.

While conventional substrates employing deep trench isolation can be useful to provide effective isolation of devices such as transistors by fully encircling the devices, they can be less suited to large passive structures such as substrate-integrated inductors and transmission lines that are typically much larger than individual transistors. This is because highly-doped wells are typically formed around the apex of each deep trench in order to impede charge accumulation near the apexes of deep trenches used for deep trench isolation which can result in unwanted current leakage paths. This charge accumulation occurs due to polysilicon in each trench acting as an electrode in a semiconductor capacitor and is mitigated by forming highly-doped regions at or around the apex of each trench. However, when the trenches are arranged in a conventional lattice of interconnected trenches, the highly-doped wells encircling or beneath each trench can form networks of conductive current paths; these networks of conductive paths can support eddy currents under large radio frequency passive devices such as inductors and transmission lines, leading to undesirable attenuation of RF signals due to resistive losses experienced by the induced eddy currents.

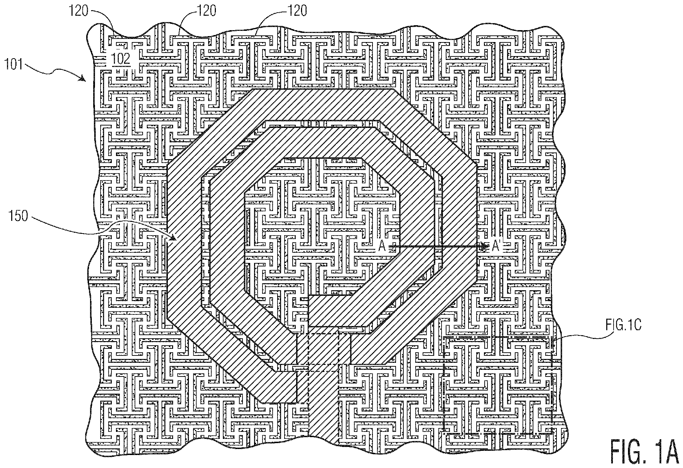

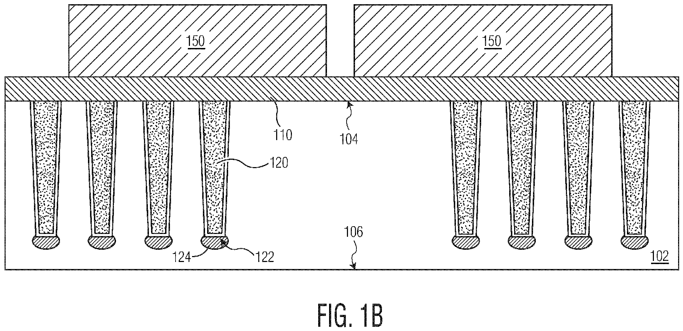

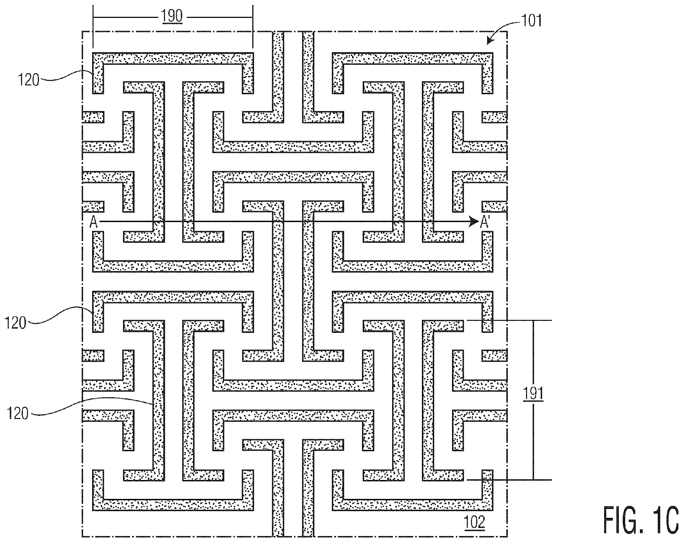

Along these lines, FIG. 1A, FIG. 1B, and FIG. 1C are illustrations of an example substrate according to one or more embodiments with deep trench isolation features arranged in a particular pattern to reduce the generation of eddy currents beneath passive devices formed on the substrate. FIG. 1A shows a passive device 150 (represented by a spiral inductor) formed above a surface of substrate 102. The passive device 150 is disposed on an insulating material 110 (shown in FIG. 1B) formed on a surface of the substrate 102 above a pattern 101 of deep trenches in the substrate 102 (which will be described in greater detail below in connection with FIG. 1C) indicated the shaded areas of FIG. 1A that are not obscured by the passive device 150. For clarity only three individual trenches 120 are labeled in FIG. 1A.

FIG. 1B shows a cross-section of the substrate 102 along the line A-A' of FIG. 1A. As shown, the cross-section of FIG. 1B passes through eight trenches 120 that extend from the upper surface 104 of the substrate 102 toward the lower surface 106 of the substrate 102. Only one of the trenches 120 and related features are labeled for clarity. The metal features forming the passive device 150 are separated from the upper surface 104 of the substrate 102 by insulating material 110 (e.g., one or more layers of silicon dioxide or another suitably electrically insulating material). Each trench 120 is lined with electrically insulating material such as silicon dioxide, as one limiting example, and filled with polysilicon as one non-limiting example. Each trench 120 extends from the upper surface 104 toward an apex 122 of that trench 120. In the example of FIG. 1B, the trenches 120 are "deep" trenches with depths of at least 1 µm, although any suitable depth can be used. As one nonlimiting example, a typical trench may be 6-8 µm deep. In embodiments herein, such deep trenches can be formed via any suitable methods including those used in conventional deep trench isolation processes.

In this example, a highly-doped region 124 is formed around the apex 122 of each trench 120, as is common in substrates with conventional deep trench isolation features. However, it will be understood that such highly-doped regions are not required and are not present in all embodiments although pat. As used herein "highly-doped" refers to a region of semiconductor material that has a free carrier concentration that is significantly higher than the surrounding semiconductor material. In general, in descriptions herein, the carrier concentration of a "highly-doped" region will be at least 100 times higher than the carrier concentration of a surrounding or adjacent "lightly-doped" region, and frequently at least one-thousand times higher. In one example, a highly-doped region has a carrier concentration that is at least ten times higher than the carrier concentration in the adjacent material. For example, the substrate 102 may be lightly-doped silicon with a carrier concentration between 10¹³ and 10¹⁴ cm⁻¹ and the carrier concentration of the highly-doped regions 124 may be greater than 10¹⁴ cm⁻¹. If the surrounding substrate is p-type, the highly-doped regions 124 will be highly-doped p-type regions and if the surrounding substrate is n-type, the highly-doped regions 124 will be highly-doped n-type regions. As above, although trenches such as the trenches 120 patterned according to embodiments herein, may mitigate undesirable electrical conduction in highly-doped regions such as the highly-doped regions 124, the presence of such highly-doped regions is not required to realize performance benefits of patterning trenches such as the trenches 120 and other trenches according to various embodiments disclosed herein.

As discussed briefly above, trenches according to embodiments herein such as the trenches 120 are arranged in specific patterns to impede the flow of eddy currents beneath passive devices such as the passive device 150. FIG. 1C shows the example pattern 101 of trenches 120 depicted in the plan view of FIG. 1A in greater detail near the line A-A' of FIG. 1A. The shaded areas indicate the trenches 120 (for clarity, only three individual trenches 120 are labeled in FIG. 1C) and the unfilled areas indicate the semiconductor material forming the bulk of the substrate 102. The pattern 101 of trenches 120 in FIG. 1C is significant because the trenches 120 are separated from each other (see also the cross-sectional view of FIG. 1B); as a result, the highly-doped regions 124 at the apexes 122 of the trenches 120 will not form continuous patterns of closed loops and the size of any other continuous conductive areas in the substrate 102 would be reduced compared to substrates with conventionally arranged trenches, even if the highly-doped regions 124 were not present. In addition, the maximum extent in either direction parallel to the surfaces 104, 106 of the substrate 102 before encountering a trench is limited. It will be appreciated that the pattern shown is a non-limiting example and that the relative dimensions and locations of trenches can be varied in different embodiments. For example, the maximum width or length of the trenches can be chosen based on an expected operating frequency range of the passive device 150.

It will be appreciated that the pattern of trenches 120 of FIG. 1C has other features which can be advantageous in various applications. As one example, the pattern 101 includes equal numbers of trenches 120 that are oriented lengthwise along two orthogonal directions (e.g., parallel to the length 190 or parallel to the length 191 shown in FIG. 1C) within planes that are parallel to the upper surface 104 and the lower surface 106 of the substrate 102. As a result, the attenuation of RF signals that propagate parallel to the upper surface 104 due to the trenches 120 will tend to be anisotropic. In addition, the pattern 101 is a periodic pattern that can be produced by translating a simple unit cell. The pattern 101 is also compatible with existing semiconductor processes used to from conventionally-patterned deep trenches. As a result, structures according to embodiments herein can be fabricated together with conventional deep trench isolation features. It will be appreciated that the pattern 101 is one non-limiting example and that any suitable pattern of trenches such as the trenches 120 can be used in different embodiments.

For ease of illustration, the passive device 150 and similar devices are depicted as being formed over a single layer of insulating material such as the layer of insulating material 110. However, it will be understood that, in one or more embodiments, such passive devices are disposed over multiple layers of insulating material and that these layers can include electrically-conductive interconnections, and other circuit components within them, including but not limited to, electrically-conductive features incorporated for mechanical or other purposes.

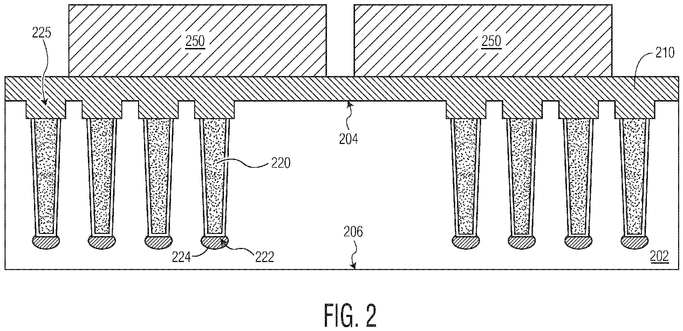

FIG. 2 shows an example substrate that is related to the substrate 102 of FIG. 1A, FIG. 1B, and FIG. 1C. The substrate 202 differs from the substrate 102 in that it includes two types of trenches: deep trenches 220 (e.g., trenches 120) and shallow trenches 225. Each deep trench 220 is formed within a wider shallow trench 225 formed at the upper surface 204 of the substrate 202. Each deep trench 220 has an apex 222 surrounded by a highly-doped region 224 (e.g., a highly-doped region 124). After formation of the deep trenches 220, the shallow trenches 225 are filled with insulating material 210 (e.g., insulating material 110). The insulating material 210 can be any suitable material(s). As above, it will be appreciated that, although the insulating material 210 is depicted as monolithic in FIG. 2, it may be formed as a single layer or multiple layers, from a single material, or any suitable combination of materials in any suitable arrangement and that electrically conductive interconnections or other circuit elements can be disposed within one or more layers of insulating material disposed beneath the passive device.

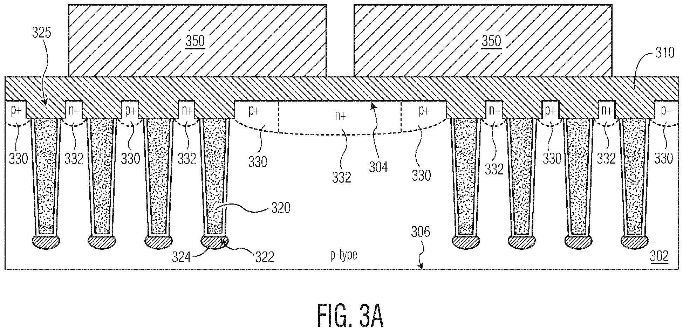

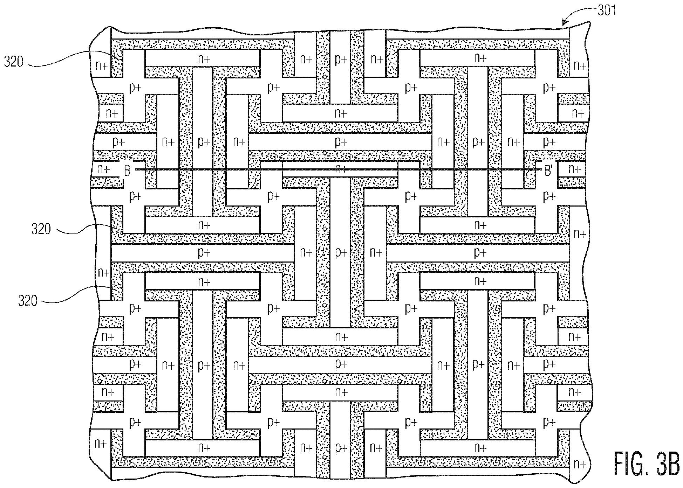

FIG. 3A and FIG. 3B illustrate additional features that are present in one or more embodiments which can be used together with the arrangements of deep and shallow trenches (e.g., deep trenches 220 and shallow trenches 225 as shown in FIG. 2) or without shallow trenches (e.g., with only trenches 120 as shown in FIG. 1). As shown in FIG. 3A, a passive device 350 (e.g., a passive device 150 or a passive device 250) is formed above the substrate 302 and separated from the semiconductor material of the substrate 302 and from the deep trenches 320 by an insulating material 310 (e.g., an insulating material 110 or 210). In the example of FIG. 3A, the semiconducting material of the 302 is doped lightly p-type and the highly-doped regions 324 at the apex 322 of each deep trench 320 are highly-doped p-type regions. The substrate 302 also includes shallow p-doped regions 330 and shallow n-doped regions 332 formed at the upper surface 304 of the substrate 302 between the deep trenches 320 (and between the shallow trenches 325). The locations of the deep trenches 320 and shallow trenches 325 are arranged according to the pattern 301 of trenches shown in FIG. 3B and the cross-section of FIG. 3A corresponds to the line B-B' of FIG. 3A.

The locations of the deep trenches 320 in the pattern 301 are similar to the locations of the trenches 120 in the pattern 101 and the line B-B' is positioned analogously to the line A-A' in FIG. 1A. The substrate 302 also includes shallow p-doped regions 330 and shallow n-doped region 332 in relation to the deep trenches 320. Locations of the shallow p-doped regions 330 and the shallow n-doped region 332 are superimposed on the pattern 301 in FIG. 3B. As shown in FIG. 3A and FIG. 3B, the shallow p-doped regions 330 330 and the shallow n-doped regions 332 are arranged in an alternating fashion around each deep trench 320 such that any closed path that encircles a trench passes through a series of p-n and n-p junctions. Collectively, this arrangement limits the maximum distance eddy currents can travel before reaching a potential barrier that prevents further electrical conduction in the substrate 302 near the deep trenches 320 (and under the passive device 350).

It will be understood that the substrate 302 is a non-limiting example and that, in one or more embodiments a substrate such as the substrate 302 is doped lightly n-type rather than p-type and that in one or more such embodiments, highly-doped region such as the highly-doped regions 324 disposed around apexes of trenches such as the deep trenches 320 are n-type rather than p-type. It will also be understood that, in one or more embodiments, an alternating pattern of doped regions such as the pattern of shown in FIG. 3A and FIG. 3B surrounds a pattern of trenches such as the pattern 101 which lacks shallow trenches such as the shallow trenches 225 or 325.

### EXAMPLES

Features of embodiments may be understood by way of one or more of the following examples.

Example 1: An electronic device method of forming an electronic device that includes a semiconductor substrate having an upper surface, a lower surface, and a doped body portion having a first conductivity type that is n-type or p-type that is disposed between the upper surface and the lower surface. One or more electrically-insulating layers are disposed above the upper surface and an electrically-conductive passive device is fabricated above the one or more electrically-insulating layers that is separated from the body portion of the substrate by the one or more electrically-insulating layers. A set of electrically-insulating isolation trenches are disposed beneath the passive device and extend from the upper surface of the substrate toward the lower surface of the substrate. The isolation trenches are disjoint from each other.

Example 2: The device or method of Example 1, in which the passive device is configured to form part of a radio-frequency circuit with a predetermined operational frequency range.

Example 3: The device or method of Example 2 in which the isolation trenches are dimensioned and arranged to impede the generation of eddy currents in the semiconductor substrate in response to radio-frequency (RF) electrical currents flowing in the passive device within the predetermined operational frequency range.

Example 4: The device or method of Example 2 or Example 3, in which the passive device is spiral inductor.

Example 5: The device or method of Example 2 or Example 3, in which the passive device is a transmission line.

Example 6: The device or method of any of Examples 1-5, wherein each isolation trench is surrounded by an electrically-insulating material and filled with an electrically-conductive material.

Example 7: The device or method of any of Examples 1-6, wherein the electrically-conductive material filling the isolation trenches is polysilicon.

Example 8: The device or method of any of Examples 1-7 that further includes a set of shallow trenches formed in the upper surface of the substrate. Each shallow trench surrounds a corresponding isolation trench each shallow trench is filled with electrically-insulating material.

Example 9: The device or method of any of Examples 1-8, that includes a first set of doped regions at the upper surface of the substrate having a first conductivity type and a second set of doped regions having a second conductivity type opposite the first conductivity type. The first set and the second set of doped regions at the upper surface are disposed between the isolation trenches and arranged such that each doped region having the first conductivity type is surrounded by two or more doped regions having the second conductivity type.

Example 10: The device or method of any of Examples 1-9 that further includes a set of heavily-doped regions of the first conductivity type disposed beneath apexes of respective isolation trenches within the body portion of the substrate between the isolation trenches and the lower surface of the substrate. The heavily-doped regions are disjoint from each other.

The preceding detailed description and Figures referenced therein are examples. They are illustrative in nature and are not intended to limit the embodiments of the Disclosure and uses of such embodiments. It should therefore be understood that embodiments of this Disclosure are not limited in their application to the details of construction and the arrangement of components set forth in the preceding Description or illustrated in the accompanying Drawings.

As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in one or more embodiments of the Disclosure.

Also, it is to be understood that the phraseology and terminology used herein is for the purpose of description and should not be regarded as limiting.

The terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner, unless stated otherwise.

In addition, certain terminology may also be used herein for the purpose of reference only, and thus are not intended to be limiting, and the terms "first," "second" and other such numerical terms referring to structures do not imply a sequence or order unless clearly indicated by the context. Thus, the terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the disclosure, for example, are capable of operation in sequences other than those illustrated or otherwise described herein.

As used herein the terms "approximate," "approximately," "substantial" and "substantially" mean sufficient to accomplish the stated purpose in a practical manner and that minor imperfections, if any, are not significant for the stated purpose. Along these lines, when used with references to measurable quantities including, but not limited to, dimensions, these terms mean that the quantities are equal to the values stated subject to accepted tolerances of any methods or apparatus chosen to fabricate the described structures and/or measure the quantities or dimensions described.

## Claims

1. An electronic device, comprising:
a semiconductor substrate having an upper surface, a lower surface, and a doped body portion having a first conductivity type that is n-type or p-type that is disposed between the upper surface and the lower surface;
one or more electrically-insulating layers disposed above the upper surface;
an electrically-conductive passive device fabricated above the one or more electrically-insulating layers that is separated from the body portion of the substrate by the one or more electrically-insulating layers; and
a set of electrically-insulating isolation trenches disposed beneath the passive device that extend from the upper surface of the substrate toward the lower surface of the substrate;
wherein the isolation trenches are disjoint from each other.

2. The electronic device of claim 1, wherein the passive device is configured to form part of a radio-frequency circuit with a predetermined operational frequency range;
and wherein the isolation trenches are dimensioned and arranged to impede the generation of eddy currents in the semiconductor substrate in response to radio-frequency (RF) electrical currents flowing in the passive device within the predetermined operational frequency range.

3. The electronic device of claim 2, wherein the passive device is spiral inductor.

4. The electronic device of claim 2, wherein the passive device is a transmission line.

5. The electronic device of any of claims 2 to 4, wherein each isolation trench is surrounded by an electrically-insulating material and filled with an electrically-conductive material.

6. The electronic device of claim 5, wherein the electrically-conductive material is polysilicon.

7. The electronic device of claim 5 or 6, further comprising a set of shallow trenches formed in the upper surface of the substrate;
wherein each shallow trench surrounds a corresponding isolation trench; and
wherein each shallow trench is filled with electrically-insulating material.

8. The electronic device of any preceding claim, further comprising:
a first set of doped regions at the upper surface of the substrate having a first conductivity type and a second set of doped regions having a second conductivity type opposite the first conductivity type;
wherein the first set and the second set of doped regions at the upper surface are disposed between the isolation trenches and arranged such that each doped region having the first conductivity type is surrounded by two or more doped regions having the second conductivity type.

9. The electronic device of any preceding claim, further comprising:
a set of heavily-doped regions of the first conductivity type disposed beneath apexes of respective isolation trenches within the body portion of the substrate between the isolation trenches and the lower surface of the substrate;
wherein the heavily-doped regions are disjoint from each other.

10. A method, comprising:
forming a set of electrically-insulating isolation trenches in a semiconductor substrate that extend from an upper surface of the substrate toward a lower surface of the substrate;
forming one or more insulating layers disposed above the upper surface of the substrate; and
forming an electrically-conductive passive device that is separated from the upper surface of the substrate by the one or more electrically-insulating layers;
wherein the isolation trenches are disjoint from each other; and
wherein the substrate comprises a doped body portion having a first conductivity type that is n-type or p-type that is disposed between the upper surface and the lower surface of the substrate.

11. The method of claim 10, wherein the passive device is configured to form part of a radio-frequency circuit with a predetermined operational frequency range;
and wherein the isolation trenches are dimensioned and arranged to impede the generation of eddy currents in the semiconductor substrate in response to radio-frequency (RF) electrical currents flowing in the passive device within the predetermined operational frequency range.

12. The method of claim 11, wherein the passive device is spiral inductor.

13. The method of claim 11, wherein the passive device is a transmission line.

14. The method of claim 11, wherein each isolation trench is surrounded by an electrically-insulating material and filled with an electrically-conductive material.

15. The method of claim 14, wherein the electrically-conductive material is polysilicon.
